# EUROPÄISCHE PATENTANMELDUNG

(11) **EP 1 172 914 A1**
(43) Veröffentlichungstag der Anmeldung: **16.01.2002**
(21) Anmeldenummer: 00810619.7
(22) Anmeldetag: 14.07.2000
(51) Int. Cl.: H02H 9/02, H01L 39/16

(54) **Supraleitender Strombegrenzer**

(71) Anmelder: ABB RESEARCH LTD., 8050 Zürich (CH)
(72) Erfinder: Chen, Makan, Dr., 5405 Baden-Dättwil (CH); Paul, Willi, Dr., 5430 Wettingen (CH)
(74) Vertreter: ABB Patent Attorneys

(57) **Zusammenfassung**

Bei hochtemperatursupraleitenden Strombegrenzern werden zwei Elemente (4,4') mit je einem Träger und einer Leiterbahn (40,40') derart zu einem Modul kombiniert, dass die in den beiden Leiterbahnen fliessenden Ströme entgegengerichtet sind und sich die für die Wechselstromverluste verantwortlichen Magnetfelder grösstenteils kompensieren. Um die Anforderungen an die elektrische Isolation zwischen den Elementen zu reduzieren, wird dafür gesorgt, dass im Begrenzungsfall die zwischen den Leiterbahnen auftretenden Potentialdifferenzen deutlich unterhalb der zwischen den Anschlusskontakten (31,32) anliegenden Modulspannung bleiben. Vorteilhafterweise werden die Leiterbahnen spiral- oder mäanderförmig ausgeführt und elektrisch parallelgeschaltet und an Stellen mit gleichem elektrischem Potential (43) durch Verbindungsleiter (5') zusätzlich verschaltet. In einer anderen Ausführungsform werden die Leiterbahnen in Teilstücken ausgeführt, die gegenseitig in Serienschaltung verbunden werden.

## Beschreibung

### TECHNISCHES GEBIET

Die vorliegende Erfindung bezieht sich auf das Gebiet der Hochtemperatursupraleitung. Sie betrifft einen supraleitenden Strombegrenzer mit verringerten Wechselstromverlusten gemäss dem Oberbegriff des Patentanspruchs 1.

### STAND DER TECHNIK

Hochtemperatursupraleiter finden beispielsweise Verwendung in supraleitenden Kurzschluss-Strombegrenzern. Bei einem solchen Strombegrenzer wird ausgenutzt, dass ein Supraleiter bei entsprechend tiefer Temperatur seine Supraleitfähigkeit nur solange beibehält, als die Stromdichte eines ihn durchfliessenden Stromes unterhalb eines gewissen, als kritische Stromdichte (j_{c}) bezeichneten Grenzwertes bleibt.

Bei elektrischen Verteil- oder Übertragungsnetzen mit supraleitenden Bauteilen fällt im Fehler- oder Begrenzungsfall unter Umständen die am entsprechenden Netzabschnitt anliegende Spannung gewollt (falls das Bauteil als Strombegrenzer ausgelegt ist) oder ungewollt am Supraleiter ab. Bei einer uniformen Stromverteilung wird der Hochtemperatursupraleiter dabei homogen über seine ganze Länge "quenchen", d.h. sich über die kritische Temperatur T_{C} erwärmen und in den resistiven Zustand übergehen. Dadurch fällt im Begrenzungsfall die Spannung über die ganze Länge des Supraleiters ab, was zu kleinen elektrischen Feldern im Supraleiter selber führt.

In Supraleitern treten im Dauerbetrieb Wechselstromverluste auf, auch wenn die Amplitude des Nennstromes I_{N} kleiner als der kritische (Gleich-)Strom I_{C} ist. Diese Verluste sind eine Folge von bestimmten Magnetfeldkomponenten innerhalb des Supraleiters und werden dadurch minimiert, indem die genannten Magnetfelder kompensiert werden. Dies wiederum geschieht bei bandförmigen Supraleitern mit einem grossen Querschnittsverhältnis von Breite zu Höhe geeigneterweise durch einen zweiten Supraleiter mit einem gleich grossen, aber in entgegengesetzter Richtung fliessenden Strom, welcher in geringem Abstand zum ersten Supraleiter angeordnet wird.

In der DE 44 34 819 A1 ist ein Strombegrenzer dargestellt, bei welchem beidseits eines Isolators je ein Leiterverbund aus einem Hochtemperatursupraleiter und einem normalleitenden elektrischen Bypass angeordnet ist. In einander direkt gegenüberliegenden Abschnitten der Leiterverbunde fliesst der Strom in entgegengesetzter Richtung. In diesem Fall sind bei ausreichend flach ausgebildeten Leitern die Wechselstromverluste umso stärker reduziert, je geringer der Abstand zwischen den beiden Leiterverbunden, d.h. je dünner der sie trennende Isolator ist. Dies entspricht bei einer Serieschaltung der Leiterverbunde gleichzeitig einer niederinduktiven Anordnung.

Hochtemperatursupraleiter sind keramische Werkstoffe, welche normalerweise auf einen Träger angewiesen sind. Im Falle von einkristallinen dünnen Schichten ist der Träger ein Substrat, welches zumindest supraleiterseitig nichtleitend ist und auf welchem der Supraleiter mittels Vakuumverfahren aufgewachsen wird. Die Schichtdicken betragen beispielsweise für Supraleiter der YBCO-Familie < 5µm. Polykristalline schmelzprozessierte Supraleiter vom Typ Bi₂Sr₂CaCu₂O₈, wie sie in der genannten DE 44 34 819 A1 eingesetzt werden, sind mit für Strombegrenzeranwendungen typischen Schichtdicken von 50-5000 µm ebenfalls nicht selbsttragend. Sie werden beispielsweise durch einen Träger in Form eines Glasfaserkunststoffes mechanisch gestützt und geschützt. Normalerweise werden die Hochtemperatursupraleiter noch durch einen normalleitenden Bypass auf Stahl- oder Nickelbasis elektrisch stabilisiert. Weiter besteht auch die Möglichkeit, fertig prozessierte supraleitende Drähte mit beliebigen Querschnitten auf einem Träger anzuordnen.

In allen Fällen werden aus herstellungstechnischen Gründen plattenförmige Elemente fabriziert, welche einen Supraleiter in Form einer quasi-2dimensionalen Leiterbahn geringer Höhe, aber für Strombegrenzeranwendungen ausreichender Gesamt-Leiterlänge umfassen. Zwei derartige Elemente werden anschliessend zu einem sogenannten Modul zusammengefügt, wobei diese durch einen der Träger oder einen sonstigen Isolator voneinander elektrisch getrennt sind.

In der DE 44 34 819 A1 sind die Leiterverbunde mäanderförmig ausgebildet und seriegeschaltet. Sind zudem mehrere Module in Serie geschaltet, so liegt im Begrenzungsfall, wenn die Supraleiter sich über ihre kritische Temperatur erwärmt haben und normalleitend geworden sind, ein entsprechender Bruchteil der gesamten *treibenden* Spannung an jedem Modul an. Liegen die beiden Anschlüsse des Moduls, d.h. der Anfang des ersten Leiterverbundes und das Ende des zweiten Leiterverbundes, nahe beieinander, so liegt an dieser Stelle die gesamte Modulspannung an und der Isolator muss entsprechend dick gewählt werden.

### DARSTELLUNG DER ERFINDUNG

Aufgabe der vorliegenden Erfindung ist es, einen Strombegrenzer auf Hochtemperatursupraleiterbasis mit zwei Leitern anzugeben, welcher unter Nennstrom geringe Wechselstromverluste aufweist und nur eine reduzierte elektrische Isolation zwischen den beiden Leitern erfordert. Diese Aufgabe wird durch eine Hochtemperatursupraleiteranordnung mit den Merkmalen des Patentanspruchs 1 gelöst.

Kern der Erfindung ist es, bei einem Strombegrenzer in Modulbauweise der eingangs genannten Art die Leiter so anzuordnen und zu verschalten, dass im Begrenzungsfall die Spannung, welche zwischen den Leitern auftritt, deutlich unter der am Modul anliegenden Modulspannung liegt, d.h. gegenüber Letzterer um mindestens einen Faktor zwei reduziert ist. Dadurch kann der Isolator, welcher die beiden Leiter trennt, dünner ausgebildet werden, so dass die Leiter einander noch näher kommen und die gegenseitige Magnetfeldkompensation und damit die Wechselstromverlustreduktion noch effektiver ist.

Vorzugsweise beträgt die genannte Spannung zwischen den Leitern nicht mehr als die Spannung, welche über einer Leiterlänge abfällt, welche der vierfachen Linearausdehnung des Moduls entspricht. In anderen Worten, die Differenz der Leiterabschnittslängen zwischen einem Punkt und dem nächstliegenden Äquipotentialpunkt sollte den Modulumfang nicht übertreffen.

In einer bevorzugten Ausführungsform sind die zwei Leiter nicht durchgehend, sondern zerfallen in Teilstücke, welche mit Teilstücken des anderen Leiters verbunden sind. Es fliesst in allen Teilstücken der Nennstrom, und es ist möglich, in allen Leiterabschnitten die Magnetfelder zu kompensieren.

In einer alternativen bevorzugten Ausführungsform fliesst in den Leitern nur der halbe Nennstrom. Bei gleicher kritischer Stromdichte weist der Leiter also nur den halben Querschnitt auf. Liegen supraleitende Leiterabschnitte ohne Magnetfeldkompensation vor, dann sind dort die Wechselstromverluste wegen der geringeren Stromstärke auch kleiner.

Vorzugsweise sind die beiden Leiter elektrisch parallelgeschaltet. Bei Äquipotentialpunkten ist es möglich, die beiden Leiter zu verbinden und so eine optimale Spannnungs- und Stromaufteilung zu erreichen. Die beiden Leiter können in mäanderform oder spiralförmig angeordnet sein.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen
Fig.1 einen Stromkreis und ein Strombegrenzermodul nach dem Stand der Technik,
Fig.2 - Fig.5 je eine nicht massstabsgetreue Schrägaufsicht eines Strombegrenzermoduls gemäss Erfindung, und
Fig.6 eine mögliche Verschaltung mehrerer Module.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

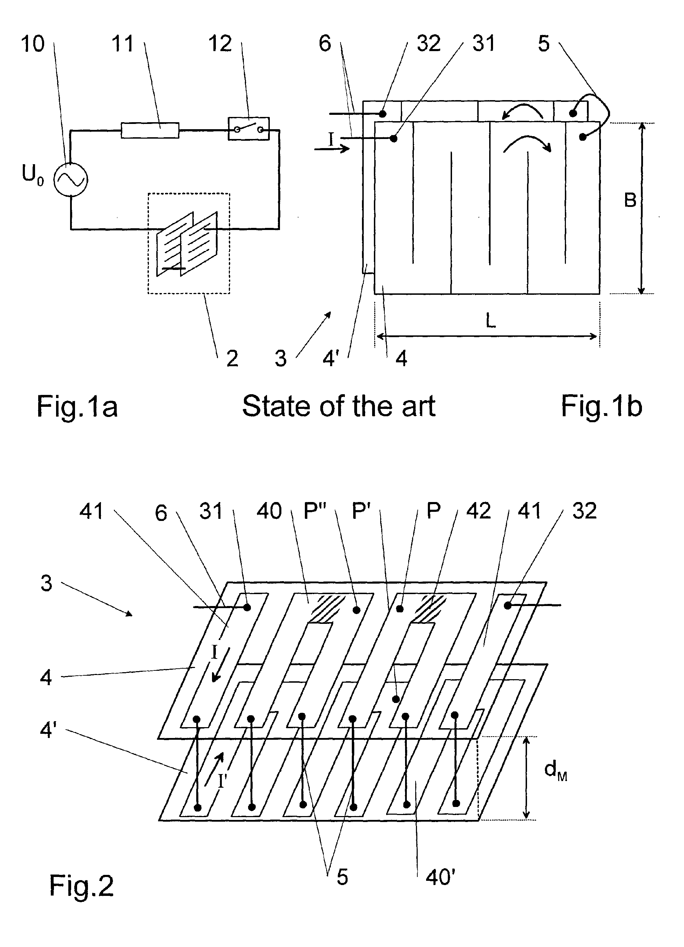

In Fig.1a ist ein Stromkreis mit einer supraleitenden Strombegrenzungsanordnung nach dem Stand der Technik gezeigt. Eine Spannungsquelle 10 erzeugt eine treibende Spannung U₀, welche im Normalfall beim Verbraucher 11 abfällt. Ebenfalls in den Stromkreis geschaltet sind ein Hauptschalter 12 und ein supraleitender Strombegrenzer 2. Solange der Hauptschalter 12 geschlossen bleibt kann, beispielsweise infolge eines Kurzschlusses im Verbraucher 12, die treibende Spannung U₀ auch ausschliesslich am Strombegrenzer 2 abfallen, wodurch dieser in bekannter Weise in seinen normalleitenden Zustand übergeht und den Fehlerstrom begrenzt.

Fig.1b zeigt ein erstes Element 4 des Strombegrenzers 2 mit einer mäanderförmigen Leiterbahn, welches mit einem zweiten derartigen Element 4' und einer zwischen den beiden Elementen liegenden nicht dargestellten Isolationsschicht ein Modul 3 bildet. An Anschlusskontakten 31,32 des Moduls 3 sind die Leiterbahnen mit normalleitenden Anschlussleitern 6 zur Einspeisung oder Abnahme des zu begrenzenden Stromes kontaktiert. Das Modul 3 ist durch eine Linearausdehnung L_{M} charakterisiert, welche bei rechteckigen Modulen gleich dem Mittelwert von Länge L und Breite B des Moduls ist und bei kreisrunden Modulen dem Durchmesser entspricht. Die effektive Leiterlänge L_{S} des Supraleiters übertrifft die Linearausdehnung L_{M} des Moduls um ein Vielfaches. Die effektive Leiterlänge L_{S} pro Element in Fig.1b ist ungefähr gleich der sechsfachen Modulbreite B. Es wird darauf geachtet, dass die für die Wechselstromverluste massgebenden Magnetfeldkomponenten grösstenteils kompensiert werden, indem die beiden Elemente 4,4' derart angeordnet und über einen Verbindungsleiter 5 seriegeschaltet werden, dass in zwei benachbarten Leiterbahnabschnitten ein Strom I,I' gleicher Stärke jeweils in entgegengesetzter Richtung fliesst. Die Potentialdifferenz im Begrenzungsfall zwischen einem Punkt des ersten Elementes 4 und einem unmittelbar benachbarten Punkt des zweiten Elementes 4' nimmt entlang der Leiterbahn ausgehend vom Maximalwert U₀ bei den Anschlusskontakten 31,32 linear auf Null ab. Insbesondere im Bereich der Anschlusskontakte 31,32 werden an die elektrische Isolation entsprechend hohe Anforderungen gestellt.

In Fig.2 ist in perspektivischer Darstellung ein erfindungsgemässes Modul 3 umfassend zwei Elemente 4,4' dargestellt. Jedes Element weist mehrere U-förmige Teilleiterbahnen 40,40' auf, wobei die auf demselben Element befindlichen Teilleiterbahnen untereinander nicht verbunden sind. Auf dem einen Element 4 befinden sich anschlussseitig zusätzlich noch zwei gerade Leiterabschnitte 41, welche über die Anschlusskontakte 31,32 mit weiteren Modulen oder direkt mit dem Stromnetz verbunden sind. Zwischen den Elementen 4,4' des Moduls befindet sich ein Isolator, welcher aus Gründen der Übersichtlichkeit nicht dargestellt ist. Die Dicke des Isolators entspricht in etwa dem Abstand d_{M} der Elemente und soll wie eingangs erwähnt im Allgemeinen so gering wie möglich sein. Um eine möglichst grosse Leiterlänge L_{S} zu erzielen, sind auch die Schenkel der U-förmigen Teilleiterbahnen einander so nahe wie möglich zu bringen, d.h. der laterale Abstand der Teilleiterbahnen in Fig.2 ist aus darstellungstechnischen Gründen übertrieben. Dadurch sind auch die für das obere Element 4 schraffiert eingezeichneten magnetisch unkompensierten Leiterabschnitte 42, welche auf dem zweiten Element 4' nicht über einen unmittelbar gegenüberliegenden und deckungsgleichen Leiterabschnitt mit entgegengesetzt gleich grosser Stromstärke verfügen, minimiert. Auf der vorderen Seite des Moduls 3 ist jeweils das eine Ende eines Teilleiters des oberen Elementes 4 mit einem Ende eines Teilleiters des unteren Elementes 4' über einen Verbindungsleiter 5 verbunden eingezeichnet. Diese Verbindung geschieht vorzugsweise über einen flexiblen Normalleiter in Form eines Silberbandes oder über einen überdimensionierten supraleitenden Draht. Alternativ dazu kann auch der Isolator an den entsprechenden Stellen mit Ausnehmungen versehen sein, so dass sich die Leiterbahnen durch minimalstes Verbiegen in direkten Kontakt bringen lassen.

Im Begrenzungsfall gehen die supraleitenden Leiterbahnen auf den Elementen 4,4' in einen normalleitenden Zustand über. Am Modul 3 fällt somit die Modulspannung U_{M} ab, welche bei nur einem Modul 3 pro Strombegrenzer 2 gleich der Spannung U₀ sein kann und bei N seriegeschalteten Modulen dem N-ten Teil davon entspricht. Erfindungsgemäss ist nun zwischen jedem Punkt P eines Elementes 4 und einem dazu unmittelbar benachbarten Punkt P' auf dem zweiten Element 4' die Spannung U_{P} auf einen Bruchteil von U_{M} begrenzt. Das Verhältnis der zu erwartenden Spannung U_{P} zur Modulspannung entspricht dem Verhältnis einer Modulbreite B zur Leiterlänge L_{S}. Maximal der doppelte Wert davon ist zu erwarten zwischen einem Punkt P und einem benachbarten Punkt P" auf einer zweiten Teilleiterbahn desselben Elementes 4. Die Anschlusskontakte 31,32 liegen an entgegengesetzten Enden des Moduls 3 und sind somit nicht nur durch die Isolatorschicht getrennt. In allen Leiterabschnitten fliesst derselbe Nennstrom I_{N}, wodurch die Magnetfelder in zwei benachbarten Leitern gleich sind und deren Kompensation am effektivsten ist.

In allen folgenden Ausführungsbeispielen wird der Nennstrom I_{N} aufgeteilt in zwei im Wesentlichen gleich grosse Hälften I,I'. In einem supraleitenden Leiterabschnitt, in welchem die Magnetfelder nicht kompensiert werden, sind die Wechselstromverluste trotzdem verringert, falls nur die halbe Stromstärke fliesst. Im Folgenden sind die zwei Elemente 4,4' jeweils deutlich voneinander getrennt gezeichnet, was einer übertriebenen, nicht massstäblichen Isolatordicke entspricht.

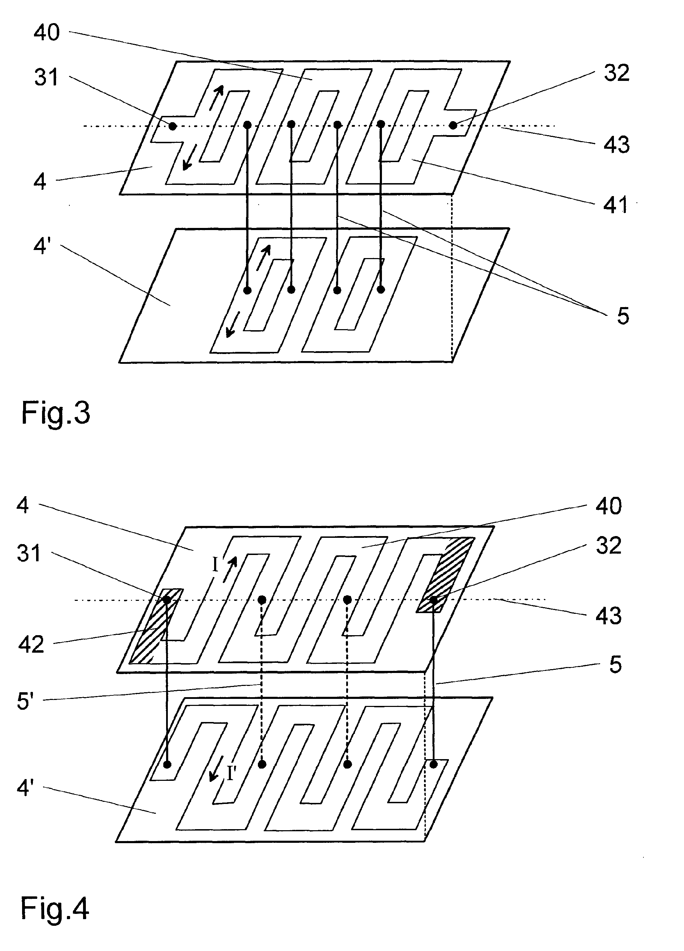

Die in Fig.3 dargestellten Elemente 4,4' eines Moduls 3 umfassen wiederum getrennte O-förmige Teilleiterbahnen 40, welche über auf einer Längsachse 43 der Elemente befindliche Verbindungsleitungen 5 mit Teilleiterbahnen 40' des jeweils anderen Elementes verbunden sind. Die anschlussseitigen Leiterabschnitte 41 umfassen zudem die Anschlusskontakte 31,32 des Moduls 3.

In Fig.4 sind die zusammenhängenden Leiterbahnen 40,40' der zwei Elemente 4,4' mäanderförmig ausgebildet und elektrisch parallelgeschaltet. Die Leiterbahnen der zwei Elemente sind anfangs- beziehungweise endseitig verbunden, so dass die Anschlusskontakte 31,32 von beiden Elementen geteilt werden. Sofern sie supraleitendes Material umfassen, sind Leiterabschnitte mit einer Gesamtlänge, welche zwei Modulbreiten entspricht, bei dieser Ausführungsform nicht magnetfeldkompensiert. Im Bereich der Anschlusskontakte 31,32 ist auf beiden Elementen je ein im oberen Element 4 schraffiert dargestellter Abschnitt der halben Modulbreite davon betroffen. Auf der Längsachse 43 der Elemente sind zwischen Äquipotentialpunkten zusätzliche Querverbindungen 5' möglich, welche zur Homogenisierung von Spannungs- und Stromverteilung beitragen. Befinden sich die Anschlusskontakte 31,32 in einer Ecke der Elemente 4,4' und nicht wie in Fig.4 dargestellt auf der Längsachse, so kommen auch die Äquipotentialpunkte an den Rand der Elemente zu liegen.

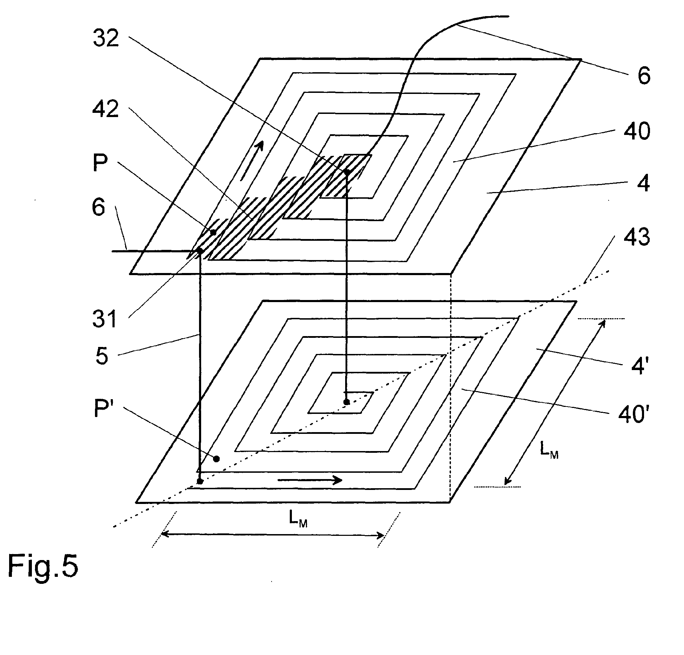

In Fig.5 sind die Leiterbahnen 40,40' auf den zwei Elementen spiralförmig ausgebildet. Eine eckige Spiralform wie dargestellt hat dabei den Vorteil, dass sie mittels gerader Schnitte in einer durchgehenden, kontinuierlichen supraleitenden Schicht einfach realisiert werden kann. Zudem ist die Magnetfeldkompensation besser, da die geometrische Überdekkung im Gegensatz zu einer runden Spirale abschnittsweise praktisch überall gewährleistet ist. Beim dargestellten Modul erfolgt die maximale Potentialdifferenz U_{P} im Begrenzungsfall zwischen den eingezeichneten Punkten P und P', es gilt jedoch auch hier U_{P} ≤ 4·L_{M}/L_{S}·U_{M}. Nachteilig ist in diesem Fall jedoch die Lage des zweiten Anschlusskontaktes 32 im Zentrum der Spirale, vom welchem aus ein zentraler Anschlussleiter 6 wegführt. Dieser Nachteil wird aber dann hinfällig, falls ein zweites Modul elektrisch in Serie mit dem ersten geschaltet und unmittelbar neben diesem aufgestellt wird, so dass der zentrale Anschlussleiter 6 beispielsweise in Stabform zentral und senkrecht zur Ebene der Leiterbahnen direkt zum zweiten Anschlusskontakt des zweiten Moduls führt. Auf einer Diagonalachse 43 befinden sich wiederum auf beiden Elementen Punkte gleichen Potentials, welche bei Bedarf über zusätzliche Verbindungsleiter 5' verbunden werden können.

Ist wie in Fig.5 der erste Anschlusskontakt 31 für beide Elemente 4,4' gemeinsam, d.h. beginnen die beiden spiralförmigen Leiter 40,40' in derselben Ecke, so befinden sich die magnetisch un- oder teilkompensierten Leiterabschnitte an den schraffierten Stellen 42 und bilden einen Bereich, welcher eine halbe Diagonale umfasst. Falls die Leiter 40,40' gegeneinander um 90° oder 180° verdreht sind und die Stromrichtung weiterhin im einen Element in Uhrzeigersinn und im anderen im Gegenuhrzeigersinn ist, so umfasst der entsprechende Bereich eine ganze Diagonale. Unter dem Gesichtspunkt der Wechselstromverluste beziehungsweise Magnetfeldkompensation ist die dargestellte Konfiguration also zu bevorzugen.

Allgemein ist zu bemerken, dass der in den Figuren nicht dargestellte Isolator entweder der Träger eines der zwei Elemente 4,4' sein kann oder eine zusätzliche Schicht mit optimierten Eigenschaften wie Dicke und Dielektrizitätskonstante. In diesem Fall haben die Träger nur eine mechanische Funktion und bilden je eine Aussenseite der Module. Die Breite der supraleitenden Leiterbahnen 40,40' ist mindestens dreimal so gross wie deren Dicke oder Höhe zu wählen. Aus den Ausführungsbeispielen ist ersichtlich, dass die elektrischen Anschlusskontakte 31,32 des Moduls 3 bevorzugt jeweils an entgegengesetzten Seiten oder zumindest am Rand und im Zentrum des Moduls 3 vorzusehen sind.

### BEZUGSZEICHENLISTE

- 10: Spannungsquelle
- 11: Verbraucher
- 12: Hauptschalter
- 2: Strombegrenzer
- 3: Modul
- 31,32: Anschlusskontakte
- 4,4': Element
- 40,40': (Teil-)leiterbahn
- 41: anschlussseitiger Leiterabschnitt
- 42: unkompensierter Leiterabschnitt
- 43: Achse mit Äquipotentialpunkten
- 5,5': Verbindungsleiter
- 6: Anschlussleiter

## Patentansprüche

1. Strombegrenzer auf Hochtemperatursupraleiterbasis,
a) umfassend mindestens ein Modul (3), an welchem im Begrenzungsfall eine Modulspannung (U_{M}) abfällt, wobei
b) das Modul (3) ein erstes und ein zweites Element (4,4') umfasst, welche durch einen Isolator elektrisch getrennt sind,
c) die Elemente (4,4') je eine Leiterbahn (40,40') aus supraleitendem Material aufweisen, in welchen im Dauerbetrieb Ströme I,I' fliessen,
d) die Elemente (4,4') zur Reduktion der Wechselstromverluste derart angeordnet sind, dass sich die zwei Leiterbahnen (40,40') in magnetischer Wechselwirkung befinden und die Ströme I,I' in den zwei Leiterbahn (40,40') vorwiegend in entgegengesetzten Richtungen fliessen,
**dadurch gekennzeichnet, dass**
e) zwischen jedem Punkt (P) der einen Leiterbahn (40) und dem nächstliegenden Punkt (P') der anderen Leiterbahn (40') im Begrenzungsfall eine Spannung U_{P} anliegt, welche kleiner ist als die halbe Modulspannung U_{M}/2.

2. Strombegrenzer nach Anspruch 1, wobei das Modul eine Linearausdehnung (L_{M}) aufweist und die Leiterbahnen (40,40') pro Element eine Leiterlänge L_{S} aufweisen, **dadurch gekennzeichnet, dass** U_{P} < 4·L_{M}/L_{S}·U_{M}.

3. Strombegrenzer nach Anspruch 1, **dadurch gekennzeichnet, dass** die Leiterbahnen (40,40') in mehrere Teilleiterbahnen zerfallen und jeweils eine Teilleiterbahn des ersten Elementes (4) mit zwei Teilleiterbahnen des zweiten Elementes (4') verbunden ist.

4. Strombegrenzer nach Anspruch 1, **dadurch gekennzeichnet, dass** die Ströme I,I' in den Leiterbahnen (L1, L2) mindestens annähernd gleich einem halben Nennstrom I_{N} des Strombegrenzers sind.

5. Strombegrenzer nach Anspruch 4, **dadurch gekennzeichnet, dass** die Leiterbahnen (40,40') in mehrere Teilleiterbahnen zerfallen und jeweils eine Teilleiterbahn des ersten Elementes (4) mit zwei Teilleiterbahnen des zweiten Elementes (4') verbunden ist.

6. Strombegrenzer nach Anspruch 4, **dadurch gekennzeichnet, dass** die Leiterbahnen (40,40') parallel geschaltet sind.

7. Strombegrenzer nach Anspruch 6, **dadurch gekennzeichnet, dass** zwischen den Leiterbahnen (40,40') an Stellen mit gleichem elektrischem Potential zusätzliche elektrische Verbindungsleiter (5') zur Spannungshomogenisierung vorgesehen sind.

8. Strombegrenzer nach Anspruch 6, **dadurch gekennzeichnet, dass** die Leiterbahnen (40,40') mäanderförmig ausgebildet sind.

9. Strombegrenzer nach Anspruch 6, **dadurch gekennzeichnet, dass** die Leiterbahnen (40,40') spiralförmig ausgebildet sind.

10. Strombegrenzer nach Anspruch 9, **dadurch gekennzeichnet, dass** die Spirale gerade Leiterbahnabschnitte umfasst.
